# EUROPÄISCHE PATENTSCHRIFT

(11) **EP 3 552 058 B1**
(45) Veröffentlichungstag und Bekanntmachung des Hinweises auf die Patenterteilung: **20.07.2022**
(21) Anmeldenummer: 17791041.1
(22) Anmeldetag: 23.10.2017
(51) Int. Cl.: G03F 7/00

(54) **VERFAHREN, VORRICHTUNG UND PRÄGEROLLE ZUM PRÄGEN VON MIKRO- UND/ODER NANOSTRUKTUREN**
METHOD, APPARATUS AND IMPRINT ROLLER FOR EMBOSSING MICRO-STRUCTURES AND/OR NANO-STRUCTURES
PROCÉDÉ, APPAREIL ET ROULEAU D'IMPRESSION POUR IMPRIMER DES MICRO- ET/OU NANOSTRUCTURES

(30) Priorität: 06.12.2016 DE 102016123538
(43) Veröffentlichungstag der Anmeldung: 16.10.2019
(73) Patentinhaber: EV Group E. Thallner GmbH, 4782 St. Florian am Inn (AT)
(72) Erfinder: KRÓL, József, 94036 Passau (DE); POVAZAY, Boris, 1220 Wien (AT)
(74) Vertreter: Schneider, Sascha
(86) Internationale Anmeldenummer: PCT/EP2017/076978
(87) Internationale Veröffentlichungsnummer: WO 2018/103940

(56) Entgegenhaltungen:
- US-A- 5 425 848
- US-A1- 2012 070 623
- US-A1- 2012 204 745

## Beschreibung

Für die Herstellung von bedruckten Bändern und Folien sind bereits mehrere unterschiedliche Technologien bekannt. Diese wurzeln im traditionellen Offsetdruck, insbesondere im Rollenoffsetdruck. Dabei werden das zu bedruckende Medium wie Papier oder Folie von einer Spenderrolle abgewickelt, mit entsprechenden Druckrollen kontinuierlich bedruckt und auf einer Empfängerrolle aufgewickelt. Es können weitere Teile wie Spann-, Umlenk-, Trockner- oder Beschichterrollen in der Druckmaschine vorhanden sein.

In der Halbleiterindustrie wird eine abgewandelte Form des Rollenoffsetdrucks zum Prägen von insbesondere Mikro- und/oder Nanostrukturen auf entsprechende Träger verwendet.

Auf einem Träger, insbesondere eine Trägerfolie wird eine Prägemasse aufgebracht, insbesondere aufgesprüht, laminiert oder getaucht. Die Prägemasse wird mit Hilfe einer strukturierten Prägerolle in einem Urformungsverfahren bearbeitet. Es ist jedoch möglich, die Prägerolle selbst nicht zu strukturieren und insbesondere eine strukturierte Schicht (bspw. Prägestrukturen auf und/oder in einer Unterlage) und die Prägemasse in Kontakt zu bringen. So rollt eine unstrukturierte Prägerolle insbesondere auf/in eine Folie aufgebrachte Struktur in eine Prägemasse ein. Damit diese Strukturierung die notwendige Formstabilität gewinnt, findet meistens eine Stoffumwandlung, die mit einer Verfestigung einhergeht, statt. In den meisten Fällen wird der Prägemasse Energie zugeführt. Diese kann insbesondere mittels Wärme-, UV- oder Mikrowellenstrahlung oder durch eine Behandlung im magnetischen, elektrischen oder elektromagnetischen Feld stattfinden. Weiterhin ist eine mechanisch eingeleitete Reaktion insbesondere bei überkritischer, metastabiler Prägemasse denkbar, wobei der Prägestempel die Zustandsänderung einleitet. Dabei kann eine Prägemasse, welche als metastabiles, statistisches Mehrteilchensystem verstanden werden kann, aus der Flüssigkeitsphase durch den Druck des Prägestempels oder einer Prägerolle in den festen Zustand gebracht werden, wobei die Einwirkung des Prägestempel die Zustandsänderung nur einleitet. Es ist weiterhin möglich, die Prägemasse im zeitlichen Ablauf (Aushärten) so zu steuern, dass die Form der Prägemasse direkt nach dem Urformen nicht mehr veränderbar ist. Dies kann mit einer bereits in der Prägemasse gestarteten insbesondere chemischen Reaktion erfolgen. Das kann eine Reaktion eines B-stage-Materials oder das Aushärten von Kleberkomponenten wie Epoxy-Resins in der Prägemasse sein, welche Chemikern und Materialwissenschaftlern bekannt ist.

Falls UV-Strahlung zur Aushärtung verwendet wird, kann das Prägeverfahren als eine Art Imprintlithographie aufgefasst werden.

Wird die Prägemasse durch das Eindringen eines Stempels, insbesondere seiner strukturierten Oberfläche, verformt, spricht man von Imprintlithographie. Wird eine Substanz von der Oberfläche der Stempelstrukturen übertragen, spricht man von Kontaktlithographie. Die Vorsilben Mikro- bzw. Nano bezeichnen die Größenordnung der verwendeten Strukturen am Stempel.

Charakteristische geprägte Strukturgrößen sind größer 10 nm, bevorzugt größer 50 nm, besonders bevorzugt größer 500 nm. Es sind jedoch geprägte Strukturgrößen von 10 Mikrometer, 30 Mikrometer bis 1 Millimeter oder 10 Millimeter möglich. Für einige Anwendungen sind Strukturgrößen in Größenordnung 100 mm oder 1000 mm möglich, insbesondere für die Herstellung von Displays oder selbstleuchtende Hinweisschilder oder fälschungssichere Drucksachen wie Eintrittskarten, Geldscheine.

Es ist jedoch auch denkbar, Strukturgrößen größer 1 nm oder 5 nm herzustellen. Dazu ist das entsprechende Zusammenspiel von den Verfahrens- und Anlagenparameter notwendig. Diese können insbesondere die Resistchemie, die Prägestrukturgeometrie und deren Herstellung, die Prägeanlage, die Reinheit der Umgebung sein.

Eine Grenze der Wirtschaftlichkeit stellen die technischen Parameter der Strukturgrößen dar. Obwohl mit einer Prägerolle in einem Erstprägen (engl. first print) genaue Strukturen erzeugt werden können, ist die Herstellung von unterschiedlichen, hochgenauen Strukturen, deren charakteristische Größen sich mehrere Zehnerpotenzen voneinander unterscheiden, mit einer Rolle oft nicht gegeben.

Um Strukturen zu prägen, welche Abweichungen von insbesondere mehreren Größenordnungen, insbesondere Zehnerpotenzen, aufweisen, können hilfsweise mehrere, insbesondere nacheinander geschaltete Prägerollen in einer Prägeanlage verwendet werden.

Werden unterschiedliche Prägerollen mit unterschiedlichen Genauigkeitsanforderungen nacheinander eingesetzt, kann die Gesamtauflösung und Reproduzierbarkeit zumindest nicht verschlechtert, insbesondere erhöht werden. Dabei ist eine Synchronisierung der Prägerollen, der Vorspannung der Trägerfolie, Ur- sowie Umformvorgänge an der Prägemasse, deren Steuerung oder rechnergestützte Regelung von enormer Bedeutung.

Die Imprintanlagen im Stand der Technik weisen unterschiedliche Nachteile auf. Negativ wirkt auf die Maßhaltigkeit der Prägemasse sowie der Trägerfolie die thermisch ungünstige Position der UV-Station in der Prägerolle oder neben der Prägerolle, dadurch sind keine stationären thermischen Zustände zu erreichen, die Ungleichmäßigkeit der Aufwärmung verursacht weitere Verzerrungen in der Prägerolle und/oder in der Prägefolie. Dies führt zur Verzerrungen in den geprägten Strukturen, also eine herabgesetzte Maßhaltigkeit.

Für Imprintanlagen mit in der Prägerolle positionierter Strahlungsquelle ist eine optische Transparenz in der Wellenlänge der Strahlung eine Grundvoraussetzung der Funktionsfähigkeit. Es soll weiterhin die Grundvoraussetzung der Eigenstabilität der Prägerolle gewährleistet sein, sodass hierfür nur Werkstoffe, welche die beiden Merkmale in Kombination aufweisen, anwendbar sein können.

Für eine kombinierte Anlage mit Strahlungsquelle in der Prägerolle ist der Aufwand, die Prägerolle für Wartungszwecke zu entnehmen größer als für Anlagen, welche keine integrierte Funktionalität aufweisen. Der Wartungsaufwand der Strahlungsquelle ist ebenfalls höher, falls die Prägerolle dazu abgebaut wird.

Es ist daher die Aufgabe der vorliegenden Erfindung, ein Verfahren und eine Vorrichtung zur Verfügung zu stellen, die die Nachteile des Stands der Technik beseitigen und insbesondere eine verbesserte Maßhaltigkeit bei verringertem Wartungsaufwand gewährleisten.

Diese Aufgabe wird mit den Merkmalen der nebengeordneten Patentansprüche gelöst. Vorteilhafte Weiterbildungen der Erfindung sind in den Unteransprüchen angegeben.

Es ist erfindungsgemäß ein Verfahren zum Prägen von Mikro und/oder Nanostrukturen vorgesehen, aufweisend die folgenden Schritte:
- Einkoppeln einer Vernetzungsstrahlung in eine für die Vernetzungsstrahlung durchsichtige, insbesondere strukturierte, Prägerolle, sodass die Prägerolle als Lichtleiter für die eingekoppelte Vernetzungsstrahlung dient,
- Auskoppeln der Vernetzungsstrahlung aus der Prägerolle,
- Aushärtung einer durch die Prägerolle beaufschlagten Prägemasse durch die ausgekoppelte Vernetzungsstrahlung.

Weiterhin ist erfindungsgemäß eine Vorrichtung zum Prägen von Mikro- und/oder Nanostrukturen vorgesehen, aufweisend:
-- ein Sendemodul zum Aussenden einer Vernetzungsstrahlung,
-- eine für die Vernetzungsstrahlung durchsichtige Prägerolle,
   wobei die Vernetzungsstrahlung in die Prägerolle einkoppelbar ist, sodass die Prägerolle als Lichtleiter für die eingekoppelte
Vernetzungsstrahlung verwendbar ist, wobei die Vernetzungsstrahlung aus der Prägerolle auskoppelbar ist und eine durch die Prägerolle beaufschlagte Prägemasse durch die ausgekoppelte Vernetzungsstrahlung aushärtbar ist.

Weiterhin ist eine Prägerolle für das erfindungsgemäße Verfahren beziehungsweise die erfindungsgemäße Vorrichtung vorgesehen.

In einer bevorzugten erfindungsgemäßen Ausführungsform ist vorgesehen, dass die Vernetzungsstrahlung an mindestens einer der Stirnflächen der Prägerolle eingekoppelt wird.

In einer anderen bevorzugten erfindungsgemäßen Ausführungsform ist vorgesehen, dass mindestens ein Sendemodul, insbesondere eine Strahlungsquelle und/oder ein Lichtwellenleiter, die Vernetzungsstrahlung in die Prägerolle einkoppelt.

In einer anderen bevorzugten erfindungsgemäßen Ausführungsform ist vorgesehen, dass das mindestens eine Sendemodul beim Einkoppeln die Prägerolle berührt. In einer alternativen bevorzugten erfindungsgemäßen Ausführungsform ist vorgesehen, dass ein Sendemodul der Vernetzungsstrahlung beim Einkoppeln die Prägerolle nicht berührt.

In einer weiteren bevorzugten erfindungsgemäßen Ausführungsform ist vorgesehen, dass ein Sendemodul der Vernetzungsstrahlung eine geeignete, insbesondere gekapselte, Flüssigkeit zur Einkopplung der Strahlung in die Prägerolle verwendet.

In einer anderen bevorzugten erfindungsgemäßen Ausführungsform ist vorgesehen, dass die Vernetzungsstrahlung UV-Strahlung ist.

In einer anderen bevorzugten erfindungsgemäßen Ausführungsform ist vorgesehen, dass mehrere Totalreflexionen der Vernetzungsstrahlung innerhalb der Prägerolle erfolgen.

In einer anderen bevorzugten erfindungsgemäßen Ausführungsform ist vorgesehen, dass die Vernetzungsstrahlung mittels frustrierter Totalreflexion aus der Prägerolle aus- und gleichzeitig in die Prägemasse zur Aushärtung eingekoppelt wird. Unter der frustrierten Totalreflexion versteht man im Allgemeinen den physikalischen Effekt des Übergangs eines evaneszenten Anteils einer, zwischen einem ersten, optisch dichten Medium und einem zweiten, optisch dünnen, Medium totalreflektierten optischen Welle, in ein drittes, optisch dichtes, Medium. Das erste und das dritte optische Medium sollten dabei ungefähr dieselbe optische Dichte besitzen, das zweite optische Medium muss eine geringere optische Dichte als die beiden erstgenannten Medien haben. Eine detailliertere Beschreibung des Effektes ist bei den Figuren aufgeführt.

In einer anderen bevorzugten erfindungsgemäßen Ausführungsform ist vorgesehen, dass die Vernetzungsstrahlung in der Prägerolle durch Mehrfachreflexionen (interne Totalreflexion und/oder Oberflächenreflexion) homogenisiert wird.

In einer anderen bevorzugten erfindungsgemäßen Ausführungsform ist vorgesehen, dass die Prägerolle so konstruiert und gebaut ist, dass deren Geometrie und/oder deren Material die Vernetzungsstrahlung, mit Ausnahme dafür vorgesehener Stellen, am Austritt aus der Prägerolle hindert. Dieser Einschluss der Vernetzungsstrahlung wird als intrinsische Beschränkung (engl.: intrinsic confinement) bezeichnet. Mathematisch gesehen stellt also die Prägerollengeometrie zusammen mit dem verwendeten Material eine Randbedingung dar, welche zu Lösungen der Maxwellschen Gleichungen der Elektrodynamik führt, die eine eingesperrte Vernetzungsstrahlung beschreiben.

In einer anderen bevorzugten erfindungsgemäßen Ausführungsform ist vorgesehen, dass die Vernetzungsstrahlung durch Streustellen ausgekoppelt wird.

In einer anderen bevorzugten erfindungsgemäßen Ausführungsform ist vorgesehen, dass die Prägemasse mittels der Prägerolle geformt wird und zeitlich minimal verzögert oder gleichzeitig die Aushärtung der Prägemasse durch die Vernetzungsstrahlung erfolgt.

In einer anderen bevorzugten erfindungsgemäßen Ausführungsform ist vorgesehen, dass eine innere Mantelfläche der Prägerolle konisch ausgebildet ist.

In einer weiteren bevorzugten erfindungsgemäßen Ausführungsform ist vorgesehen, dass eine innere Mantelfläche der Prägerolle eine für die Anwendung der Lichtleitung optimierte Freiformfläche aufweist. Diese können insbesondere torisch, durch mathematische Funktionen exakt beschreibbar oder experimentell ermittelte Flächen bedeuten.

In einer anderen bevorzugten erfindungsgemäßen Ausführungsform ist vorgesehen, dass eine interne Mantelfläche der Prägerolle Reflektoren, insbesondere Retroreflektoren, enthält oder als Reflektor, insbesondere Retroreflektor, ausgebildet ist.

In einer anderen bevorzugten erfindungsgemäßen Ausführungsform ist vorgesehen, dass mindestens eine der Stirnflächen der Prägerolle für die Strahlungseinkopplung mit Teilverspiegelungen und/oder Rillen und/oder Kerben und/oder Einbuchtungen versehen ist.

In einer anderen bevorzugten erfindungsgemäßen Ausführungsform ist vorgesehen, dass an der Prägerolle für die Strahlungseinkopplung zusätzliche optische Elemente, insbesondere optische Keile, Linsen, Prismen, Blenden und/oder Spiegel verwendet werden.

In einer anderen bevorzugten erfindungsgemäßen Ausführungsform ist vorgesehen, dass die Vernetzungsstrahlung einseitig, insbesondere in eine Stirnfläche der Prägerolle, einkoppelbar ist und die gegenüberliegende Stirnfläche totalverspiegelt ist.

In einer anderen bevorzugten erfindungsgemäßen Ausführungsform ist vorgesehen, dass die Vernetzungsstrahlung an der inneren oder äußeren Mantelfläche der Prägerolle eingekoppelt wird, wobei beide Stirnflächen der Prägerolle verspiegelt sein können. Dabei kann die Einkopplung nah zu den Stirnflächen erfolgen.

In einer anderen bevorzugten erfindungsgemäßen Ausführungsform ist vorgesehen, dass die äußere Mantelfläche der Prägerolle nicht zylinderförmig ausgebildet ist. Es sind insbesondere abrollbare Freiformflächen möglich, um auf konkav gekrümmten Oberflächen prägen zu können. Es können insbesondere elliptische oder durch sog. Freilinien (engl. splines) beschreibbare äußere Mantelflächen als Prägerolle verwendet werden.

Das erfindungsgemäße Verfahren sowie die erfindungsgemäßen Anlagen koppeln die Vernetzungsstrahlung, insbesondere UV-Strahlung, in die für die Vernetzungsstrahlung durchsichtige Prägerolle ein, insbesondere an mindestens einer der Stirnflächen der Prägerolle. Die Prägerolle wird dabei als Lichtleiter für die Vernetzungsstrahlung verwendet.

Die Strahlung wird in einer erfindungsgemäßen Ausführungsform mittels frustrierter Totalreflexion aus der Prägerolle aus- und gleichzeitig in die Prägemasse zur Aushärtung eingekoppelt.

In einer anderen Ausführungsform kann die Auskopplung der Strahlung mit Anpassung und Angleichen der Brechungsindizes der Prägerolle und der Prägemasse so erfolgen, dass an der Kontaktstelle zwischen Prägerolle und Prägemasse keine Totalreflexion stattfindet.

In einer anderen Ausführungsform kann die Auskopplung der Vernetzungsstrahlung durch Anbringen von Streustellen an der nicht an der Prägemasse angrenzenden Mantelfläche der Prägerolle erfolgen.

Die, bevorzugt innere, Mantelfläche der Prägerolle kann strukturiert, insbesondere mit periodischem Muster, ausgeführt sein. Es ist eine Strukturierung wie das Ergebnis einer Sandstrahlung und/oder Schleifen und/oder Aufbürsten denkbar. Somit ist die, bevorzugt innere, Mantelfläche der Prägerolle als optisch gestörte Fläche zu verstehen, welche als Streustellen die Strahlung aus der Prägerolle in Richtung der äußeren Mantelfläche der Prägerolle auskoppelt und in die Prägemasse einkoppelt. Die charakteristische Strukturgröße der inneren Mantelfläche der Prägerolle zur Störstellenbildung liegt im Mikrometer bis Nanometerbereich, insbesondere in der Größenordnung der Wellenlänge der Vernetzungsstrahlung.

Durch die Einkopplung der Vernetzungsstrahlung an mindestens einer Stirnfläche der Prägerolle sind die geometrischen Beschränkungen der Prägerolle bezüglich Größe für die Lichtquelle, thermische Beschränkungen wegen unkontrollierten Wärmeflüssen, Kopplungen elektrischer und mechanischer Art für drehende Objekte, die einen Abrieb herstellen und für das Imprinten negativ sind, beseitigt. Somit können insbesondere Durchmesser der Prägerolle und/oder Material von der Art der Strahlungsquelle unabhängig zweckmäßig ausgelegt werden.

Einen weiteren Vorteil stellt die Verwendung des Prinzips "Funktionswerkstoff an Funktionsstelle" dar. Darunter versteht man, dass abhängig von der jeweiligen Funktionsstelle auch der korrekte Funktionswerkstoff verwendet wird.

Beispielsweise wird ein Funktionswerkstoff mit hoher Festigkeit für den Grundkörper der Prägerolle verwendet, während ein Funktionswerkstoff mit entsprechenden optischen Eigenschaften die notwendige Funktionalisierung der Oberfläche der Prägerolle sowie die Einkopplung und Auskopplung einer zielgerichteten, homogenen Vernetzungsstrahlung sicherstellt.

In einer weiteren Ausführungsform können mechanische und/oder thermische und/oder fluidische und/oder messtechnische Komponenten insbesondere innerhalb des äußeren Durchmessers des Grundkörpers der Prägerolle platziert werden. Insbesondere können Antriebssysteme, Heizer- und/oder Kühlsysteme mitsamt Temperaturfühler im Grundkörper der Prägerolle funktionsintegriert werden.

In einer weiteren Ausführungsform kann die Prägerolle segmentiert ausgeführt werden, sodass sich die Vernetzungsstrahlung konzentriert im verwendeten Segment ausbreiten kann. Dadurch wird eine höhere Strahlungsintensität in die Prägemasse übertragen, wodurch die Aushärtungszeit verkürzt wird und die Produktivität des Verfahrens bzw. der Anlage gesteigert werden kann.

Durch mehrmalige Totalreflexion in der Prägerolle kann eine homogene Ausleuchtung der Prägemasse erreicht werden. Die Homogenität der Ausleuchtung mittels Vernetzungsstrahlung der Prägemasse führt zu gleichmäßiger Vernetzung, welche für die Verfahrensstabilität von enormer Bedeutung ist.

Für eine homogene, zielgerichtete Ausleuchtung der Prägemasse wird insbesondere eine konische Grundform der Prägerolle verwendet, wobei die innere Mantelfläche der Prägerolle konisch ausgebildet sein kann. Damit können eine eindeutige Positionsfestlegung der Prägerolle und somit engere Toleranzen von Vorteil sein. Ist die innere Mantelfläche der Prägerolle zylindrisch ausgeführt, ist eine laterale Verschiebung auf einem steifen Grundkörper nur mittels weiteren konstruktiven Merkmalen wie Schulter oder Abstandhalter festzulegen.

Ein konisch geformter Zylinderkörper, der Kegel, kann, insbesondere selbsthemmend, in einer Prägerolle mit konischer Bohrung, der Kegelbohrung, fixiert werden. Somit werden bis auf einen für das Imprinten notwendigen rotatorischen Freiheitsgrad alle weiteren Freiheitsgrade durch die Paarung, welche im übertragenen Sinne als Kegel in einer Kegelbohrung verstanden werden kann, eindeutig -- und nicht überbestimmt --entfernt.

Es ist vorteilhaft eine verkeilungsfreie Ausführungsform vorhanden, welche den Tausch der Prägerolle maßgeblich erleichtert. Sollte der Grenzfall einer Verkeilung bei der inneren Kegel-Kegel-Kontaktfläche vorkommen, entfallen insbesondere sämtliche weitere Befestigungsmittel und/oder Vorspannungsmittel der Prägerolle.

Die Eigenschaften der Prägemasse müssen den Imprintbedingungen angepasst werden, welche die Fließeigenschaften bzw. Formstabilität beim Imprinten, Transparenz, Absorptionsverhalten, Vernetzungsverhalten und Vernetzungsgeschwindigkeit betreffen.

Die durchsichtige, insbesondere strukturierte, Prägerolle muss eine für die Prägemasse möglichst niedrige Adhäsionseigenschaft aufweisen. Die Adhäsion, auch Bindungsenergiedichte genannt, wird vorzugsweise über die Energie pro Flächeneinheit definiert, die notwendig ist, um zwei miteinander verbundene Oberflächen voneinander zu trennen. Die Energie wird dabei in J/m2 angegeben. Die Energie pro Einheitsfläche ist dabei geringer als 2.5 J/m2, mit Vorzug kleiner als 0.1 J/m2, mit größerem Vorzug kleiner als 0.01 J/m2, mit größtem Vorzug kleiner als 0.001 J/m2, mit allergrößtem Vorzug kleiner als 0.0001 J/m2, am bevorzugtesten kleiner als 0.00001 J/m2. Ein typischer empirisch gemessener Mittelwert der Energie pro Flächeneinheit zwischen einem Beschichtungsmaterial und einem Polymer liegt bei ca. 0.1 J/m2. Ein typischer empirisch gemessener Mittelwert der Energie pro Flächeneinheit zwischen reinem Silizium und demselben Polymer liegt bei ca. 1.2 J/m2.

Gleichzeitig müssen die Fließeigenschaften der Prägemasse so eingestellt sein, dass die strukturierte äußere Mantelfläche der Prägerolle lückenlos und blasenfrei abgebildet wird. Die Fließeigenschaft wird maßgeblich durch die Viskosität bestimmt. Die Viskosität ist eine physikalische Eigenschaft, die stark temperaturabhängig ist. Die Viskosität nimmt im Allgemeinen mit zunehmender Temperatur ab. Die Viskosität liegt bei Raumtemperatur zwischen 10E6 mPa^{∗}s und 1 mPa^{∗}s, vorzugsweise zwischen 10E5 mPa^{∗}s und 1 mPa^{∗}s, noch bevorzugter zwischen 10E4 mPa^{∗}s und 1 mPa^{∗}s, am bevorzugtesten zwischen 10E3 mPa^{∗}s und 1 mPa^{∗}s.

Die Imprintgeschwindigkeit muss so gewählt werden, dass möglichst keine Vernetzung der Prägemasse auf der Rolle erfolgt und somit die strukturierte Prägerolle hierdurch nicht unbrauchbar wird.

Wenn eine Vernetzung der Prägemasse auf der Prägerolle erfolgt und diese mit Veränderung der Viskosität, insbesondere mit einer exponentiellen Erhöhung der Viskosität einhergeht, soll die Trennbarkeit der Prägemasse und Prägerolle gewährleistet werden.

Wenn bei ausreichender Formstabilität der geprägten Prägemasse eine Trennung von der Prägerolle ohne Vernetzung stattfindet, kann eine Vernetzung zu einem späteren Zeitpunkt, ohne Berücksichtigung der Veränderungen der Adhäsionseigenschaften der Prägemasse erfolgen.

Die imprintlithographischen Vorgänge werden als Verfahren beschrieben, welche durch Rezepte gelenkt werden. Rezepte sind optimierte Wertesammlungen von Parametern, die im funktionalen oder verfahrenstechnischen Zusammenhang stehen. Die Nutzung von Rezepten erlaubt es, eine Reproduzierbarkeit von Produktionsabläufen zu gewährleisten. Diese Reproduzierbarkeit der Ergebnisse wird unter anderem als Qualität verstanden.

Für die Qualität der Imprintlithographie müssen Merkmale definiert und unterteilt werden. Qualitätskriterien für alle Verfahren sowie für die ausführenden Anlagen sind unter anderem die Gleichmäßigkeit (Homogenität) der geprägten Strukturen, Schichtdicken, Restschichtdicken sowie Defektfreiheit der erzeugten Schicht, Maß- und Formtreue der geprägten Strukturen, usw.

Die Qualitätskriterien lassen sich bspw. in drei Oberbegriffe unterteilen: Eingangs-, Prozess- sowie Ausgangsmerkmale.

Zu den Eingangsmerkmalen zählen bspw. alle Trägerfolienparameter, nicht abänderbare Maschinenparameter, nicht beeinflussbare Umgebungsbedingungen wie bspw. die lokale Gravitationskonstante am Aufstellungsort.

Die üblichen Trägerfolien können Polykarbonat (PC), Polymethylmethacrylat (PMMA), Polyethylenterephthalat (PET), Polystyrol (PS), Polyimid (PI), Polyethylenterephtalat (PTFE) oder weitere Kunststoffe beinhalten. Es können auch Metallfolien verwendet werden, welche Aluminium oder Eisen oder Molybdän oder Wolfram oder Titan oder Niob oder Zirkonium beinhalten. Es ist denkbar, faserverstärktes Material, welches Kohlenstoff oder Silizium beinhaltet, zu verwenden.

In besonderen Fällen ist die Imprintlithographie auf starren, insbesondere ebenen, Flächen denkbar. Es wird die Relativbewegung der Prägerolle und des Trägers zum Imprinten verwendet. Somit ist es möglich, insbesondere Flachglasplatten, Metallplatten oder Substrate, insbesondere Halbleiter, insbesondere welche folgende Stoffe oder Atome oder Verbindungen beinhalten können GaAs, GaN, InP, InxGa1-xN, InSb, InAs, GaSb, AlN, InN, GaP, BeTe, ZnO, CuInGaSe2, ZnS, ZnSe, ZnTe, CdS, CdSe, CdTe, Hg(1-x)Cd(x)Te, BeSe, HgS, AlxGa1-xAs, GaS, GaSe, GaTe, InS, InSe, InTe, CuInSe2, CuInS2, CuInGaS2, SiC, SiGe, SixNy, Si vollflächig, reproduzierbar und kostengünstig zu strukturieren.

Besonders wichtig für das Prägen ist die Dicke sowie die Dehnbarkeit und/oder Reißfestigkeit der Trägerfolie.

Die Trägerfolien können eine Dicke größer 10 Mikrometer, bevorzugt größer 50 Mikrometer, besonders bevorzugt größer 100 Mikrometer, ganz besonders bevorzugt größer 500 Mikrometer betragen. Es ist prinzipiell möglich, Trägerfoliendicken größer 1000 Mikrometer ebenfalls zu bedrucken.

Die Dehnbarkeit der Trägerfolie ist ein Maß für die Maßhaltigkeit der geprägten Strukturen. Wird die Trägerfolie gedehnt oder gefalzt oder wellig, können keine identischen Strukturen geprägt werden. Deswegen soll die Trägerfolie eine Dehnbarkeit kleiner 10%, bevorzugt kleiner 5%, besonders bevorzugt kleiner 1%, im optimalen Fall kleiner 0,1%, im Idealfall 0% besitzen.

Für die Produktivität einer Imprintanlage ist die Vorschubgeschwindigkeit von essentieller Bedeutung. Die Vorschubgeschwindigkeit kann größer 0,01 m/min, bevorzugt größer 0,1 m/min, besonders bevorzugt größer 0,5 m/min, ganz besonders bevorzugt größer 1 m/min, im optimalen Fall größer 10 m/min, im Idealfall größer 20 m/min betragen.

Stand der Technik stellt bspw. US5425848, US2012/204745 A1 und US2012/070623 A1 dar. In den industrieüblichen Verfahren kann die Strahlung zum Aushärten im Inneren des Prägezylinders erzeugt werden, welche für die Strahlung durchsichtig sein muss. In anderen industrieüblichen Anlagen wird die Aushärtung nach dem Prägen in einer Beleuchtungseinheit durchgeführt.

Als Verfahrensmerkmale werden alle Merkmale verstanden, die das Aufbringen der Prägemasse auf der Trägerfolie betreffen: bspw. Trägerfolienvorbereitung und Prägemassenvorbereitung, das Aufbringen als Vorgang selbst sowie die Nachbehandlung der geprägten Strukturen, welche weiterhin an die Trägerfolie gekoppelt sind bis zum nächsten Bearbeitungsschritt.

Als Ausgangsmerkmale gelten alle Merkmale, die die Prägemasse mittels Imprintlithographieverfahren verändert haben, seien es energetische, materielle Veränderungen oder am Informationsgehalt, welche bspw. in der/den Strukturgeometrie/n kodiert ist/sind.

Das Erreichen der Qualitätskriterien setzt ein Zusammenspiel aller Eingangssowie Verfahrensmerkmale voraus, damit die Ausgangsmerkmale reproduzierbar erreicht werden. Dieses Zusammenspiel ist also von Seiten der Imprintanlage, des Verfahrens und der verwendeten Materialien (Prägemasse sowie Trägerfolie, Prägerolle, Anlagenwerkstoffe) sowie bspw. Trägerfolienbeschaffenheit, Trägerfolienmaterial, Sauberkeit, Umgebungsbedingungen geprägt.

Das allgemeine Verfahren, welches die Imprintlithographie von auf endlose Trägerfolien aufgebrachter Prägemasse betrifft und mittels Imprintanlagen ausgeführt werden kann, besteht im Wesentlichen aus den folgenden Teilschritten, wobei bekannte Untergliederungen der Teilschritte als Allgemeinwissen des Fachmannes vorausgesetzt werden.

In einem Rezept werden die Verfahrensmerkmale zielgerichtet zusammengefasst und die Teilschritte in sinnvoller Kombination erstellt. Die Rezepte können sowohl als Anweisungssätze in maschinenverständlicher Form oder für den Operator bereitgestellt werden. Die Ausführung des Rezeptes, um die Verfahrensmerkmale umzusetzen, welche auf den Imprintanlagen erfolgt, wird hier beschrieben. Auf die Beschreibung vorbereitender Verfahrensschritte wird an dieser Stelle verzichtet.

### Herstellung der Prägerolle

Die Prägerolle kann gemäß den Ausführungen in der Druckschrift EP2761371 hergestellt werden. In einer weiteren erfindungsgemäß offenbarten Ausführungsform kann ein als negativ strukturierter Master mittels Elektronenstrahllithographie, Atomkraftmikroskopie, Liga-Verfahren oder mittels Röntgenstrahllithographie oder sonstigen Herstellungsverfahren als erstes Teilverfahren erzeugt werden.

Als zweites Teilverfahren kann der Master in einem Prägeverfahren analog zum offenbarten Verfahren auf die äußere Mantelfläche der Prägerolle übertragen werden. Dazu werden der Master und die Prägerolle relativ zueinander abgerollt und vernetzt.

In einem dritten Teilverfahren wird mindestens eine der Stirnflächen für die Strahlungseinkopplung funktionalisiert: Es können Teilverspiegelungen und/oder Rillen und/oder Kerben erzeugt werden. Soll die Strahlung einseitig eingekoppelt werden, kann die gegenüberliegende Stirnfläche der Prägerolle totalverspiegelt werden. Mit der Funktionalisierung der Strahlungseinkopplung werden die optischen Verluste zwischen Strahlungsquelle und Prägerolle minimiert, bevorzugt eliminiert.

Charakteristisch für Strahlungsquellen ist die elektrische Anschlussleistung, welche in der Größenordnung 1 W bis 10 kW, bevorzugt 100 W bis 7 kW, besonders bevorzugt 500 W bis 5 kW liegt.

Die optische Leistung für Strahlungsquellen fallen in die Größenordnung 1 mW bis 1 kW, bevorzugt 1 W bis 1 kW, besonders bevorzugt 100 W bis 1 kW.

Die Differenz zwischen elektrischer Anschlussleistung und optischer Leistung wird als Verlustleistung meistens als Wärme durch entsprechende Kühlmittel sowie Kühlvorrichtungen, welche dem Fachmann bekannt sind, abgeführt. Übliche Wellenlängen für die Strahlungsquellen sind die g und/oder h und/oder i-Linien von Quecksilberhochdruckbogenlampen. Die Erzeugung dieser bekannten Wellenlängen ist mit beliebigen zweckmäßigen Mitteln wie Halbleiterlaser oder LEDs, andere Gasentladungslampen möglich. Es ist in einer beispielhaften erfindungsgemäßen Ausführungsform möglich, optische Wandler für die Wellenlängenwandlung bzw. Frequenzwandlung der Strahlung zu verwenden. Es ist insbesondere erfindungsgemäß möglich, im Wellenlängenbereich ab 240 nm bis ca. 1000 nm auf die chemischen Eigenschaften wie Vernetzungswellenlänge(n), Viskosität, Zusammensetzung, Brechungsindex, Brechungsindexänderung wegen Aushärtung, Glasübergangstemperatur usw. der Prägemasse abgestimmte Strahlungsquellen zu verwenden.

Die Abstimmung der chemischen Eigenschaften der Prägemasse und einer Strahlungsquelle, insbesondere eine LED-Strahlungsquelle, bevorzugt mit der Wellenlänge 365 nm ist wegen der hohen Strahlungsausbeute bei geringer Hitzeentwicklung von Vorteil.

In einem vierten Teilverfahren kann die fertiggestellte Prägerolle, insbesondere optisch, bevorzugt mittels monochromatischer, kohärenter Strahlung, bevorzugt mittels Speckle-Interferometrie, vermessen werden.

### Ausführungsbeispiel eines erfindungsgemäßen Verfahrens

In einem ersten Schritt wird die Trägerfolie, insbesondere aufgewickelt auf einer Rolle, in die Imprintanlage eingebracht. Es sollen außerdem die Initialprüfungen wie Vorhandensein von den notwendigen Medien (bspw. Druckluft, Vakuum, Prägemasse), Deionisierung, Funktionalität der Luftfilter, Plausibilität der Sensorenwerte der Mess- und Regelinstrumente durchgeführt werden.

In diesem Schritt kann der Vorlauf der Trägerfolie, deren Vorspannung, Lage, optische Transparenz ebenfalls kontrolliert werden.

Es ist denkbar, in diesem Schritt die Strahlungsquelle, insbesondere automatisch, zu überprüfen, ob sich Position, Ausgangsintensität oder andere Parameter innerhalb des im Rezept vorgegebenen Parameterfelds befinden. Falls Fehler auftreten, kann das Verfahren erfindungsgemäß terminiert werden.

In einem nächsten Schritt wird die Prägemasse auf die zu prägende Seite oder auf die zu prägenden beiden Seiten der Trägerfolie aufgetragen. Als Option wird eine laminierte Prägemasse verwendet.

In einem nächsten Schritt wird die Strahlung in die, insbesondere rotierende, Prägerolle im Zeitablauf kontinuierlich oder getaktet, d.h. unterbrochen, eingeleitet.

In einem nächsten Schritt wird die Prägemasse mittels der Prägerolle geformt. Zeitlich minimal verzögert oder gleichzeitig wird im vierten erfindungsgemäßen Schritt die Vernetzung der Prägemasse mittels Energiezufuhr oder Zustandsänderung, insbesondere durch UV-Strahlung, eingeleitet.

Dabei ist es insbesondere wichtig, eine homogene Energiezufuhr zu gewährleisten. Insbesondere die optische Homogenität der UV-Strahlung soll in einem Wertebereich von 70 % bis 100%, bevorzugt 80% bis 100%, besonders bevorzugt 90% bis 100%, ganz besonders bevorzugt ab 95% bis 100% liegen.

Für das Prägeergebnis ist insbesondere die Energiedichte der Vernetzungsstrahlung maßgebend. Dementsprechend wird eine durch die Prägemasse an der Prägefolie oder allgemein am Substrat gemessene Energiedichte zwischen 5 mW/cm2 und 2000 mW/cm2, bevorzugt zwischen 10 mW/cm2 und 1000 mW/cm2, besonders bevorzugt zwischen 100 und 700 mW/cm2 als Bestrahlungsdichte verwendet.

In einem nächsten Schritt werden die Prägerolle und die geprägte Trägerfolie mit den fertiggestellten Strukturen, insbesondere kontinuierlich, getrennt.

In einem nächsten Schritt wird die Trägerfolie zur Weiterprozessierung auf eine Empfängerrolle aufgerollt.

In einer Weiterbildung des Verfahrens können mehrere Prägerollen nacheinander auf die Prägemasse einwirken.

In einer anderen Weiterbildung des erfindungsgemäßen Verfahrens können zwei Prägerollen, insbesondere gleichzeitig, die beidseitig aufgebrachte Prägemasse bearbeiten. Es ist auch eine örtliche Trennung der Prägerollen denkbar, sodass die jeweilige Prägerolle die Prägemasse mit der Trägerfolie gegen nicht weiter präzisierte Stützrollen oder Stützflächen drücken kann.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Fig. 1a: eine schematische Darstellung einer ersten erfindungsgemäßen Ausführungsform einer Prägerolle,
- Fig. 1b: eine schematische Darstellung einer zweiten erfindungsgemäßen Ausführungsform einer Prägerolle,
- Fig. 1c: eine schematische Darstellung einer dritten erfindungsgemäßen Ausführungsform einer Prägerolle,
- Fig. 1d: eine schematische Darstellung einer vierten erfindungsgemäßen Ausführungsform einer Prägerolle,
- Fig. 1e: eine schematische Darstellung einer fünften erfindungsgemäßen Ausführungsform einer Prägerolle,
- Fig. 1f: eine schematische Darstellung einer sechsten erfindungsgemäßen Ausführungsform einer Prägerolle,
- Fig. 1g: eine schematische Darstellung einer siebten erfindungsgemäßen Ausführungsform einer Prägerolle,
- Fig. 1h: eine schematische Darstellung einer achten erfindungsgemäßen Ausführungsform einer Prägerolle,
- Fig. 2a: eine schematische Darstellung einer erfindungsgemäßen Ausführungsform mittels frustrierter Totalreflexion,
- Fig. 2b: eine schematische Darstellung einer erfindungsgemäßen Ausführungsform mittels Störstellenauskopplung,
- Fig. 3a: eine schematische Darstellung einer Totalreflexion,
- Fig. 3b: eine schematische Darstellung eines Intensitätsverlaufs an einer Grenzfläche,
- Fig. 3c: eine schematische Darstellung einer frustrierten Totalreflexion,
- Fig. 3d: eine schematische Darstellung eines Intensitätsverlaufs an einer Grenzfläche mittels frustrierter Totalreflexion,
- Fig. 4: eine schematische Blockdarstellung des Ablaufs eines erfindungsgemäßen Verfahrens,
- Fig. 5: eine schematische Darstellung einer erfindungsgemäßen Vorrichtung.

In den Figuren sind gleiche Bauteile oder Bauteile mit der gleichen Funktion mit den gleichen Bezugszeichen gekennzeichnet.

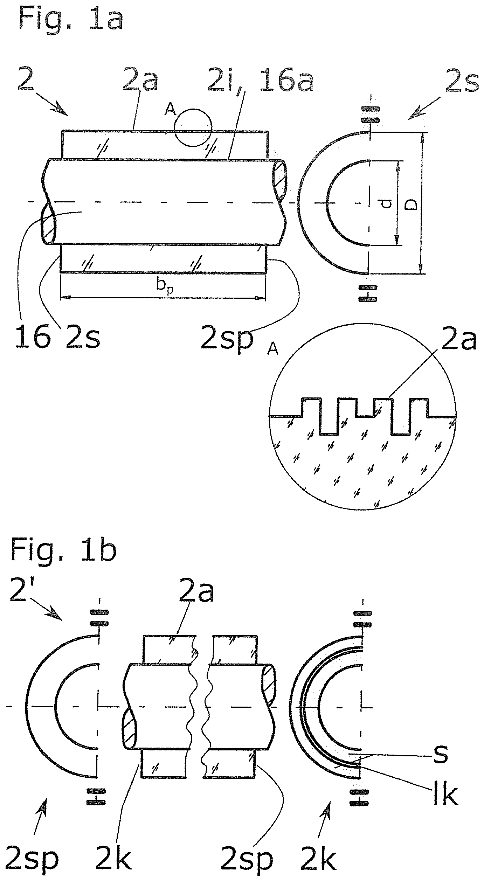

Fig. 1a ist eine schematische Darstellung einer ersten erfindungsgemäßen Ausführungsform eines Prägemoduls 2, insbesondere einer Prägerolle 2. Dargestellt sind links eine Draufsicht, rechts eine Seitenansicht und unten eine vergrößerte Ansicht des Ausschnitts A. Die Prägerolle 2 besitzt eine charakteristische Breite bp, welche an die Breite eines Trägermaterials angepasst sein kann. Am Außendurchmesser D der Prägerolle 2 befindet sich eine, insbesondere strukturierte, Außenmantelfläche 2a. Die Außenmantelfläche 2a kann breiter sein als die charakteristische Breite bp, welche als Prägebreite verstanden werden kann.

Die Außenmantelfläche 2a besitzt vorzugsweise eine sehr geringe Adhäsionseigenschaft zur Prägemasse. Die Adhäsion wird vorzugsweise über die Energie pro Flächeneinheit definiert, die notwendig ist, um zwei miteinander verbundene Oberflächen voneinander zu trennen. Die Energie wird dabei in J/m2 angegeben. Die Energie pro Einheitsfläche ist dabei geringer als 2.5 J/m2, mit Vorzug kleiner als 0.1 J/m2, mit größerem Vorzug kleiner als 0.01 J/m2, mit größtem Vorzug kleiner als 0.001 J/m2, mit allergrößtem Vorzug kleiner als 0.0001 J/m2, am bevorzugtesten kleiner als 0.00001 J/m2. Die niedrige Adhäsion kann entweder auf die Oberflächeneigenschaften des Mantelmaterials selbst zurückzuführen sein, oder der Mantel wird mit einem Material beschichtet, das eine entsprechend geringe Adhäsion aufweist.

Die Detailansicht A zeigt eine strukturierte Oberfläche in schematischer Darstellung. Die Außenmantelfläche 2a kann in anderen Ausführungen auch nicht strukturiert ausgeführt sein.

Der Mantel besteht entweder aus einem sehr weichen oder einem sehr harten Material. Für die Härte existieren verschiedene, technologische Kenngrößen. Das korrekte Härtemessverfahren hängt von vielen Einflussfaktoren ab. Die wichtigsten Faktoren sind das zu prüfende Material, sowie der Prüfkörper. Metalle und Keramiken, also Festkörper mit entsprechend hoher Festigkeit und/oder entsprechendem Plastizitätsvermögen, werden vorwiegend, aber nicht ausschließlich mit Härteverfahren nach Rockwell, Brinell und Vickers getestet.

Die Umrechnung der einzelnen Härtemesswerte ist bedingt möglich. Entsprechende Tabellen und Formeln existieren und sind dem Fachmann bekannt. Es muss allerdings erwähnt werden, dass eine exakte Umrechnung nicht immer möglich bzw. ungenau ist. Folgende Härtemessewerte beziehen sich auf die Härte nach Vickers.

Die Vickershärte für einen Mantel, der aus einem harten Material gefertigt wurde, ist größer als 10, vorzugsweise größer als 100, noch bevorzugter größer als 500, am bevorzugtesten größer als 2000, am allerbevorzugtesten größer als 4000.

Die Vickershärte für einen Mantel, der aus einem weichen Material gefertigt wurde, ist kleiner als 4000, vorzugsweise kleiner als 2000, noch bevorzugter kleiner als 500, am bevorzugtesten kleiner als 100, am allerbevorzugtesten kleiner als 10.

Die Elastizität wird durch den E-Modul beschrieben. Der E-Modul des Mantels liegt dabei zwischen 1 GPa und 1000 GPa, bevorzugt zwischen 10 GPa und 1000 GPa, mit größerem Vorzug zwischen 25 GPa und 1000 GPa, mit größtem Vorzug zwischen 50 GPa und 1000 GPa, am bevorzugtesten zwischen 75 GPa und 1000 GPa. Der E-Modul von einigen Stahlsorten liegt beispielsweise bei um die 200 GPa. Der E-Modul von SiO2 liegt zwischen 60 GPa und 80 GPa.

Die Stirnfläche 2s der Prägerolle 2 dient zur Einkopplung der Vernetzungsstrahlung (auch Aushärtungsstrahlung genannt). Die andere Stirnfläche 2sp der Prägerolle 2 kann zum besseren Wirkungsgrad verspiegelt ausgeführt sein. Am Innendurchmesser d der Prägerolle 2 koppelt konzentrisch die insbesondere zylindrische Innenmantelfläche 2i an eine Außenmantelfläche 16a eines, insbesondere festen, Zylinderkörpers 16, welcher die Form, die Stabilität und die wesentlichen mechanischen sowie thermischen Eigenschaften des Prägemoduls 2 bestimmt.

Der Zylinderkörper 16 kann zum mechanischen Antrieb gekoppelt sein, es können im Inneren des Zylinderkörpers 16 thermische, und/oder induktive Heizer, Sensoren wie Temperaturfühler, Drucksensoren, Durchbiegungssensoren, Wärmesenken wie eine Kühlung, insbesondere Flüssigkeitskühlung, speziell eine Wasserkühlung untergebracht werden. Diese sind in der Abbildung nicht explizit aufgeführt.

Die Temperatur der Prägerolle 2 wird vorzugsweise, insbesondere während der Einkopplung der elektromagnetischen Strahlung, konstant gehalten. Die Abweichung der Temperatur der Prägerolle 2 von der gewünschten Temperatur ist kleiner als 10°C, vorzugsweise kleiner als 5°C, noch bevorzugter kleiner als 2°C, am bevorzugtesten kleiner als 1°C, am allerbevorzugtesten 0°C.

Die charakteristische Breite der Prägerolle bp und die charakteristische Traglänge des Zylinderkörpers 16 (nicht extra gekennzeichnet) können gleich lang sein. In einer anderen Ausführungsform kann bp kleiner als die charakteristische Traglänge des Zylinderkörpers 16 sein. In einer anderen Ausführungsform kann bp größer sein als die charakteristische Traglänge des Zylinderkörpers 16.

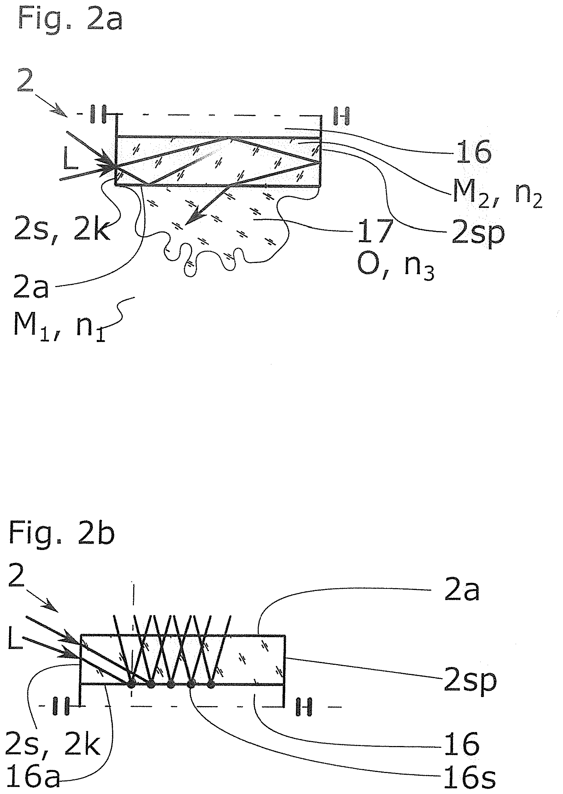

Die optischen Eigenschaften der Ausführungsformen werden hier vereinfacht dargestellt. Die Außenmantelfläche 2a der Prägerolle 2 kann optisch als eine Grenzfläche G betrachtet werden. Das Material der Prägerolle 2 besteht mit einem Brechungsindex n2 aus einem optisch dichteren Medium M2 als die Umgebung, welche ein optisch dünneres Medium M1 mit einem Brechungsindex n1 besitzt, vgl. dazu auch Fig. 2a.

Der Mantel, also der Volumenkörper, der von den Oberflächen 2a, 2i, 2s, 2sp begrenzt wird, besitzt eine Transparenz, die größer ist als 40%, vorzugsweise größer als 60%, am bevorzugtesten größer als 80%, am allerbevorzugtesten größer als 99,5%, am allerbevorzugtesten größer als 99,9%

In einer weiteren speziellen erfindungsgemäßen Ausführungsform ist es denkbar, falls die Prägerolle 2 die entsprechenden Eigenschaften aufweist, einen Antrieb an der Außenmantelfläche 2a der Prägerolle 2 einzusetzen. So kann der Raumabschnitt einer innen hohl ausgebildeten Prägerolle 2 für Sensorik o. ä. verwendet werden. Auf einen Zylinderkörper 16 kann in diesem Fall verzichtet werden.

Fig. 1b ist eine schematische Darstellung einer zweiten erfindungsgemäßen Ausführungsform einer Prägerolle 2'. In Analogie zur Fig. 1a besitzt die Prägerolle 2' eine äußere, zylindrische Mantelfläche 2a, welche das Negativ der zu prägenden Strukturen besitzen kann, aber in anderen Ausführungsformen unstrukturiert sein kann. Die Unterschiede können auf den Stirnflächen der Prägerolle 2' existieren: eine Stirnfläche 2sp kann identisch sein zu Fig. 1a, die andere Stirnfläche 2k kann eine als konzentrische Kreise ausgeführte Teilverspiegelung s besitzen, wobei ein umlaufender nicht verspiegelter Kreisring 1k als Lichtkopplung angewendet wird. Diese Ausführungsform besitzt durch die beidseitige zumindest teilweise Verspiegelung der Stirnflächen einen höheren optischen Wirkungsgrad durch die Reduzierung unerwünschter Abstrahlungsverluste.

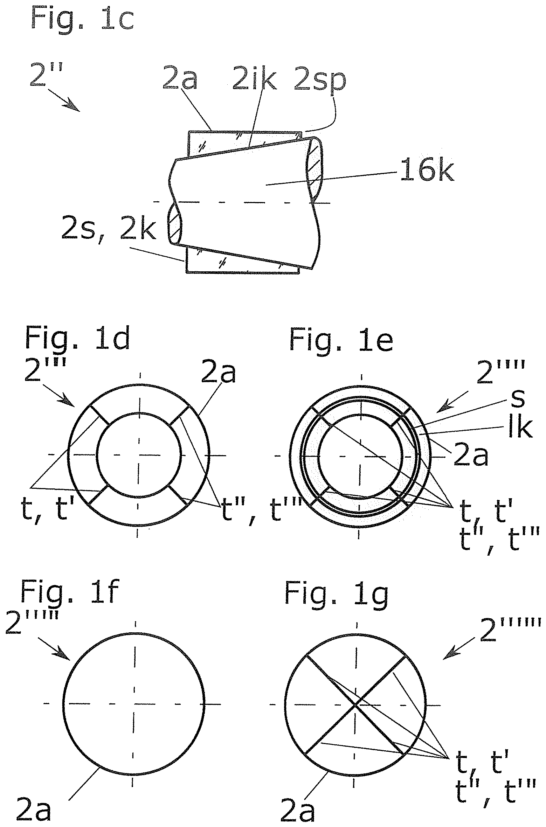

Fig. 1c ist eine schematische Darstellung einer dritten erfindungsgemäßen Ausführungsform einer Prägerolle 2". In dieser Ausführungsform gelten die Erläuterungen, welche bei Fig. 1a-1b aufgeführt sind. Die Unterschiede bestehen darin, dass der Zylinderkörper 16 an der äußeren Mantelfläche 16k konisch ausgeführt ist. Übliche Konuswinkel betragen mehr als 0 Grad, bevorzugt mehr als 1 Grad, noch bevorzugter mehr als 5 Grad, am bevorzugtesten mehr als 10 Grad, am allerbevorzugtesten mehr als 15 Grad. Die Winkel sind in Abhängigkeit des Intensitätsabfalls in der Prägerolle 2" auszulegen. Die innere Mantelfläche 2ik der Prägerolle 2" ist identisch konisch wie die Mantelfläche 16a ausgeführt, sodass eine komplette, gleichmäßige Schmiegung der beiden Oberflächen entsteht. Die äußere Mantelfläche 2a der Prägerolle 2" ist weiterhin zylindrisch ausgeführt. Die Stirnflächen können wie bei Fig. 1a oder 1b als verspiegelt 2sp, unverspiegelt 2s oder teilverspiegelt 2k ausgeführt sein.

Es ist in einer weiteren, nicht abgebildeten erfindungsgemäßen Ausführungsform vorteilhaft, dass ein Zylinderkörper mit der Prägerolle entsprechend einer mathematisch beschreibbaren, optimierten Freiformfläche in entsprechender Schmiegung miteinander verbunden werden.

Fig. 1d ist eine schematische Darstellung einer vierten erfindungsgemäßen Ausführungsform einer Prägerolle 2‴. Im Unterschied zu Fig. 1a-1c wird die Prägerolle 2‴ segmentiert ausgeführt. Die Segmente werden durch strahlungsundurchlässige Trennwände t, t', t", t‴ voneinander so separiert, dass die Ausbreitung der Strahlung immer auf ein Segment begrenzt sein kann. Dies kann mit einer Modifizierung der Prägerolle 2‴ ausgeführt sein. In einer weiteren Ausführungsform können insbesondere spiegelnde Elemente in der Prägerolle 2‴ eingebracht sein. Dadurch lassen sich höhere eingekoppelte sowie ausgekoppelte Strahlungsleistungen und eventuell bei mehreren Strahlungsquellen mit unterschiedlichen Spektren differenziertere Prägevorgänge ermöglichen.

Fig. 1e ist eine schematische Darstellung einer fünften erfindungsgemäßen Ausführungsform einer Prägerolle 2"". Zusätzlich zu Fig. 1d werden die Enden der segmentierten Prägerolle 2"" analog zu Fig. 1b teilverspiegelt mit Verspiegelungsanteilen s und Lichtkopplungsanteil 1k ausgeführt. Die Anzahl der Trennwände t, t', t", t‴ kann aus einer Menge M{0, 1, 2, 3, 4, 5, 6, 7, 8, 9, 10, mehr als 10} entnommen werden.

Die äußere Mantelfläche der Prägerolle 2"" kann strukturiert oder nicht strukturiert ausgeführt sein.

Fig. 1f ist eine schematische Darstellung einer sechsten erfindungsgemäßen Ausführungsform einer Prägerolle 2ʺ‴, wobei die Prägerolle 2ʺ‴ kernlos als Vollkörper ausgeführt ist. Es ist jedoch möglich, andere, nicht rollenförmige, sondern stempelartige Druckkörper als Prägerolle 2ʺ‴ zu definieren, welche kein Abrollen, sondern eine Linearbewegung zum Prägen verwenden. Dementsprechend kann die äußere Mantelfläche der Prägerolle 2ʺ‴ zu einer ebenen Stempelfläche transformiert werden.

Fig. 1g ist eine schematische Darstellung einer siebten erfindungsgemäßen Ausführungsform einer Prägerolle 2""", welche als eine Kombination aus Fig. 1d und Fig. 1f bzw. Fig. 1e aufgefasst werden kann. Demnach besteht die Prägerolle 2""", insbesondere die äußere Mantelfläche der Prägerolle 2""" aus Teilen, welche durch Trennwände t, t', t", t‴ voneinander getrennt sind. Es gelten die dort genannten Merkmale in Analogie.

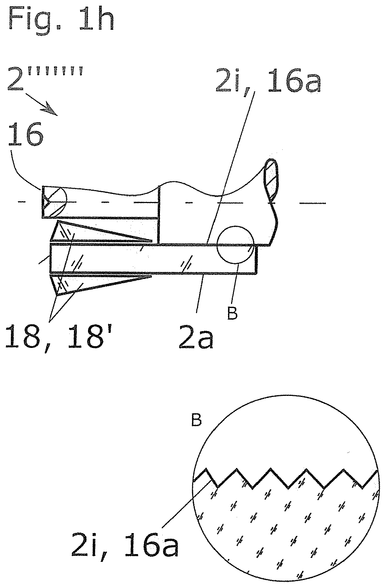

Fig. 1h ist eine schematische Darstellung einer achten erfindungsgemäßen Ausführungsform einer Prägerolle 2‴‴′. Es sind an und/oder nah zu der inneren funktionellen Mantelfläche 2i der Prägerolle optische Elemente 18 zur Strahlungseinkopplung und Strahlformung bei der Strahlungseinkopplung insbesondere als optische Keile schematisch abgebildet. Die Strahlungseinkopplung kann bevorzugt durch frustrierte Totalreflexion erfolgen. Der Zylinderkörper 16 kann entsprechend ausgeformt sein, dass die Vernetzungsstrahlung in die funktionelle Schicht der Prägerolle eingekoppelt werden kann.

Weiterhin kann der Zylinderkörper 16 und/oder die innere funktionelle Mantelfläche 2i der Prägerolle strukturiert sein. Für die Strukturen können insbesondere Retroreflektoren, Katzenaugenstrukturen für eine Lenkung der internen Totalreflexion(en) oder der Oberflächenreflexion(en) verwendet werden. Die typische Größe der Einzelstrukturen ist größer 0,1 mm, bevorzugt größer 0,5mm, bevorzugter größer 1 mm, besonders bevorzugt größer 2 mm, idealerweise größer 5 mm. Es ist alternativ denkbar, Reflektoren kleiner 0,1 mm oder größer 10 mm zu verwenden.

Der Öffnungswinkel der Retroreflektoren ist in Größenordnung 0,01° bis 180° zweckmäßig in Abhängigkeit der Vernetzungsstrahlung und der Strukturgrößen auslegbar. Bevorzugte Winkel für Retroreflektoren sind 90°+/- 5°. Die Berechnungen sind dem Fachmann bekannt. Die Vernetzungsstrahlung kann in einer weiteren erfindungsgemäßen Ausführungsform in die äußere funktionelle Mantelfläche 2a der Prägerolle eingekoppelt werden.

In einer weiteren erfindungsgemäßen Ausführungsform ist eine Parallelkopplung der Vernetzungsstrahlung prinzipiell denkbar, dann wird sowohl in die innere funktionelle Mantelfläche 2i als auch in die äußere funktionelle Mantelfläche 2a eingekoppelt.

Fig. 2a ist eine schematische Darstellung einer erfindungsgemäßen Ausführungsform mittels frustrierter Totalreflexion. Hier wird die Ausführungsform aus Fig. 1a-1h mit exemplarischen Strahlengängen L ergänzt. Die mehrmalige Totalreflexion mit insbesondere aufgeweiteten Strahlen ist schematisch dargestellt, wobei eine homogene Ausleuchtung der Prägerolle sowie das homogene Auskoppeln der Strahlung in die Prägemasse 17 erfolgt. Weiterhin gehören zur Prägerolle 2 der Zylinderkörper 16, die Stirnflächen zur Einkopplung 2k, 2s sowie verspiegelte Stirnfläche 2sp. Ohne Proportionalität wird die Prägemasse 17 symbolisch dargestellt, wobei der Strahlungseintritt ebenfalls abgebildet ist. Die innere Mantelfläche ist verspiegelt oder durch innere Totalreflexion strahlungsundurchlässig.

Fig. 2b ist eine schematische Darstellung einer erfindungsgemäßen Ausführungsform mittels Störstellenauskopplung. Die erfindungsgemäß offenbarte Prägerolle 2 wird in einer Ausführungsform, wie in Fig. 1a-1h beispielhaft dargestellt ist, verwendet. Die Einkopplung der Strahlung erfolgt in Analogie zu den vorherigen Figuren.

Für den Zweck der übersichtlichen Darstellung wird der Strahlengang in der Prägerolle nicht komplett dargestellt. Es wird auf die Darstellung der Prägemasse, welche die äußere Zylindermantelfläche der Prägerolle berührt, verzichtet. Die Einkopplung des Strahles wird mit L angedeutet. Ein stochastisch verlaufender Strahlengang in der Prägerolle wird nicht dargestellt. Es wird lediglich schematisch die Auskopplung mittels Störstellen 16s mit statistisch gleichverteilten Auskopplungsstrahlungskegeln angedeutet.

Die Homogenität der ausgekoppelten Strahlung wird von den Parametern Verteilung, Form, sowie Größe der Störstellen bestimmt. Die Auslegung der Störstellen wird für den Fachmann als bekannt vorausgesetzt. Störstellen können als Streuzentren interpretiert werden.

Die Mantelfläche 16a des Zylinderkörpers 16 wird nicht poliert oder geläppt, also mit hoher Oberflächengüte erzeugt, sondern mit Störstellen 16s versehen. Diese können insbesondere als gebürstete Oberfläche ausgeführt sein. Es können gezielt Strukturierungsspuren von Sandstrahlen oder geätzte Korngrenzen vorhanden sein.

Die Oberfläche 16a darf stochastisch gleich verteilte kleinperiodische Abweichungen von der mathematisch optimalen Form der Fläche haben, welche in Größenordnung der Strahlungswellenlänge liegen sollen. Somit ist eine homogene Ausleuchtung der Prägemasse zu erreichen. Der Strahlengang der Strahlung L soll wie bei Fig. 2a dargestellt verstanden werden.

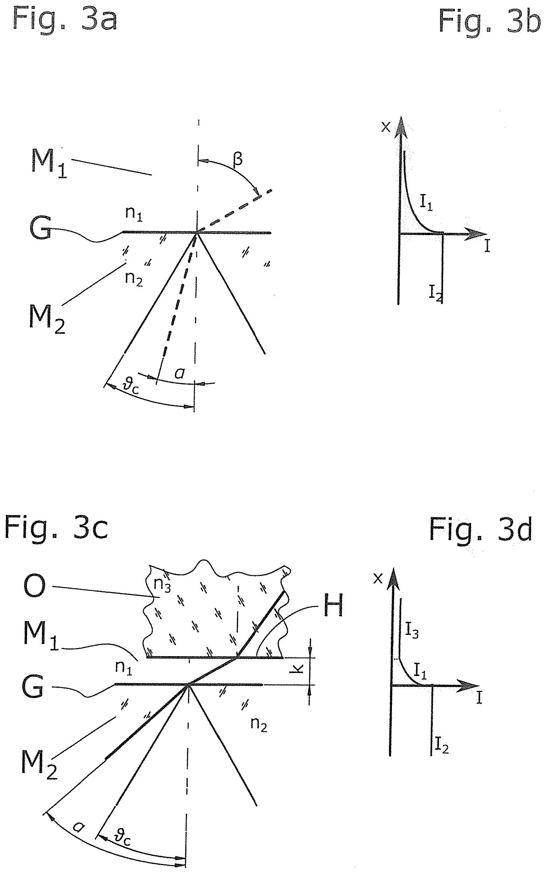

Fig. 3a ist eine schematische Darstellung der Totalreflexion sowie des Intensitätsverlaufs an einer Grenzfläche G. Es werden hier vereinfacht die Ansätze der geometrischen Optik verwendet. Somit gibt es beim Austritt eines Lichtstrahls aus einem optisch dichteren Medium M2 mit dem Brechungsindex n2 in ein optisch dünneres Medium M1 mit dem Brechungsindex n1 einen kritischen Winkel ϑc, ab welchem eine Totalreflexion stattfindet und keine Strahlung ins optisch dünnere Medium ausgekoppelt wird. Diese Regeln sind den fachkundigen Ingenieuren und Physikern bekannt. Weiterhin ist ein Strahlengang eines schiefen Strahles dargestellt, welche im dichteren optischen Medium zum Lot in Winkel α, also beim Austritt vom Lot in Winkel β gebrochen wird.

Das nebenstehende Diagramm Fig. 3b zeigt eine Intensitätsverteilung eines totalreflektieren Strahles, wobei die Intensität I als Funktion des Normalabstandes x zur Oberfläche nicht maßstabsgetreu dargestellt wird.

Die Intensität des totalreflektierten Strahles im optisch dichteren Medium M2 wird als konstant mit der Größe I2 dargestellt. Nahe der Grenzfläche ist ein dem Fachmann bekanntes wellenoptisches Phänomen, die sogenannte Lichthaut, zu beobachten. Dementsprechend ist die Intensität I1 im Medium M1 mit dem Brechungsindex n1 proportional zu dem Reziprokwert der Exponentialfunktion e. Dies ist auf evaneszente Wellen zurückzuführen.

Fig. 3b ist eine schematische Darstellung des qualitativen Intensitätsverlaufs I₁ der evaneszenten Welle und Intensitätsverlaufs I₂ des totalreflektierten Strahls an einer Grenzfläche G.

Gemäß Fig. 3c ist nahe der Grenzfläche G im Abstand k ein Objekt O mit dem Brechungsindex n3 vorhanden. Der Brechungsindex n1 ist kleiner als der Brechungsindex n3. Falls der Abstand k klein genug ist (Null oder größer), befindet sich das Objekt O mit dem Brechungsindex n3 in der Lichthaut. So wird zumindest ein Teil der Strahlung (entsprechende Absorptionseigenschaften vorausgesetzt) in O absorbiert. Somit ist eine Auskopplung der totalreflektierten Strahlung aus dem Medium M1 in O möglich.

Eine Intensitätsverteilung eines frustriert totalreflektierenden Strahles wird nur qualitativ in Fig. 3d dargestellt, wobei die Intensität I als Funktion der Ausbreitungsrichtung x dargestellt wird.

Im Medium M2 wird die Intensität I₂ als konstant betrachtet. Ab der Grenzfläche G ist die Intensität im Medium M1 mit dem Brechungsindex n1 proportional zu dem Reziprokwert der Exponentialfunktion e. An der Grenzfläche H wird die Restintensität I₃ ins Medium O eingekoppelt und angenommen konstant im Medium O weitergeleitet.

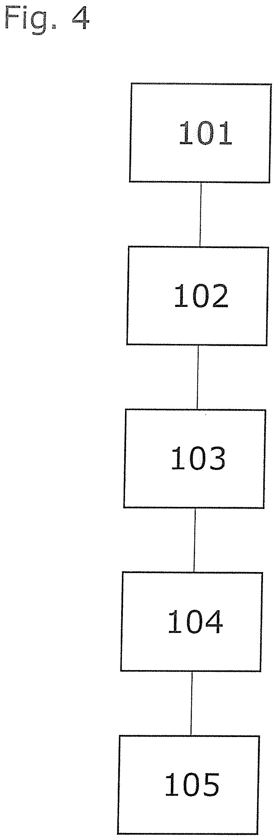

Fig. 4 ist eine schematische Blockdarstellung eines erfindungsgemäßen Imprintverfahrens.

Im ersten Schritt 101 wird die Strahlung in die Prägerolle eingekoppelt.

Im zweiten Schritt 102 wird ein Kontakt der Prägemasse mit der Prägerolle initiiert.

Im dritten Schritt 103 erfolgt die Auskopplung der Strahlung aus der Prägerolle mit gleichzeitiger Einkopplung der Strahlung in die Prägemasse. Somit wird eine Aushärtung initiiert.

Im vierten Schritt 104 wird die Prägerolle von der Prägemasse getrennt.

Im fünften Schritt 105 wird die Prägerolle kontinuierlich gereinigt und für das wiederholte Prägen vorbereitet, sodass insbesondere Schritt 101 erneut eingeleitet werden kann.

Die Schritte 101 und 102 können auch miteinander vertauscht sein.

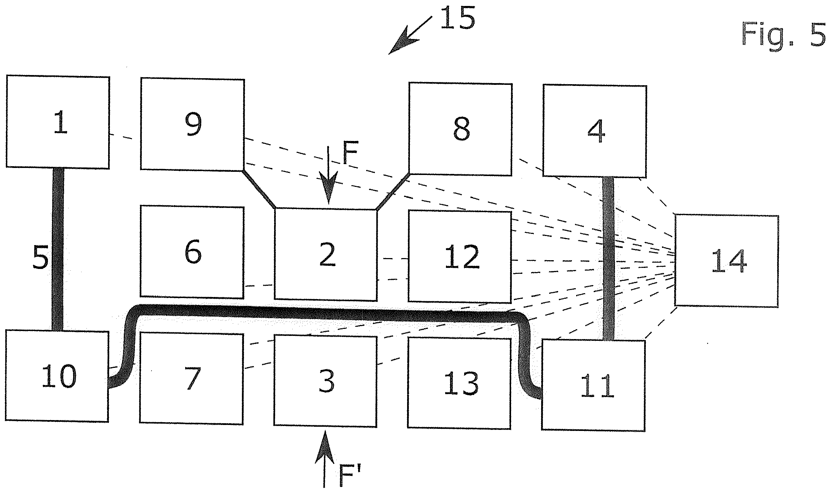

Fig. 5 ist eine Darstellung des Schemas einer erfindungsgemäßen Imprintanlage. Die Imprintanlage 15 besteht aus einer Kombination und Kopplung der aufgeführten Module: Das Trägermaterial 5, insbesondere eine Trägerfolie, durchläuft von einem Sendemodul 1 das Prägeverfahren bis zum Empfängermodul 4. Das Prägen findet am und/oder im Prägemodul 2 statt, welche als Prägerolle 2 ausgeführt sein kann. Es wirkt eine Prägekraft F, welche insbesondere durch ein Stützmodul 3 aufgenommen wird, wobei dieses mit einer Gegenkraft F' signalisiert wird.

Es können Antriebe 8 (Motoren mit oder ohne Getriebe) für das Erzeugen der Relativbewegung zwischen Prägemasse und Prägemodul, insbesondere Prägerolle, verwendet werden. Es können insbesondere die Trägerfolie mit der Prägemasse und die Prägerolle aufeinander abrollen. Weitere Kraft- bzw. Druckerzeugungselemente 8 können die Kraft (Druck) erzeugen. Dies kann auf hydraulische und/oder pneumatische und/oder mechanische und/oder elektronischer und/oder elektromagnetische Weise erfolgen.

Für das Erzeugen der Aushärtungsstrahlung wird ein Strahlungsmodul 9 mit dem Prägemodul gekoppelt. Im Strahlungsmodul können mindestens eine Strahlungsquelle (LED- oder LED-array, oder Quecksilberdampflampe, oder Halogenstrahler, oder Laser, oder Magnetronen, oder sonstige Laufzeitröhren), strahlformende Elemente wie Spiegel, halbdurchlässige Spiegel, Linsen, Prismen, Lichtleiter, Blenden, weitere Hilfsaggregate wie Kühlung enthalten sein.

Nach dem Sendemodul 1 durchläuft das Trägermaterial 5 insbesondere ein Führungs- und/oder Vorspannungs- und/oder Fügemodul 10, welches Untermodule für Reinigungs- und/oder Deionisierstationen enthalten kann, um eine eventuelle statische Aufladung des Trägers entgegenzuwirken sowie eventuelle Partikel vom Träger zu entfernen. Es können als nächstes Modul ein oberes Beschichtungsmodul 6 und/oder optional ein unteres Beschichtungsmodul 7 folgen. In weiteren Ausführungsformen können diese Module das Entfernen von Deckfolien und das Freilegen der Prägemasse bewerkstelligen. Die Module 6 und 7 dosieren die Prägemasse, formen, entfernen überschüssiges Lösungsmittel und/oder bereiten das Prägen vor.

Als darauffolgendes Modul kann das Prägemodul 2 mit dem erfindungsgemäßen Verfahren und Hilfsaggregaten versehen sein.

Es können nachgeschaltete Module folgen, wie Modul 12 sowie Modul 13, welche insbesondere eine Schutzschicht und/oder eine Schutzfolie aufbringen können und/oder eine vollständige Aushärtung durchführen können.

Es kann eine weitere Deionisierstation und/oder ein Vorspannungs- und/oder Regelungs- und/oder Führungsmodul 11 vor dem Empfängermodul 4 geschaltet werden. Die Imprintanlage 15 kann mit einem Mess- und/oder Steuerungs- und/oder Regelungsmodul oder Modulen 14 kontrolliert und beeinflusst werden, um bspw. Durchsatz, Qualität, Prozessgleichmäßigkeit sowie Stabilität aufrecht zu erhalten. Die Vernetzung aller Module mit dem Steuerungs- und/oder Regelungsmodul 14 wird mit Strichlinien symbolisiert.

Es ist in einer weiteren, nicht dargestellten Ausführungsform der Imprintanlage 15 möglich, einzelne Module miteinander zu kombinieren. Beispielsweise kann das Imprintmodul 2 das Antriebsmodul 8 und/oder das Strahlungsmodul 9 in sich integrieren. Weiterhin ist es möglich, das Sendemodul 1 mit dem Führungs- und/oder Vorspannungs- und/oder Fügemodul 10 zu kombinieren. Eine weitere Möglichkeit ist die Mehrfachintegration des Sendemoduls 1 mit dem Fügemodul 10 sowie mit den Beschichtungsmodulen 6 und/oder dem Beschichtungsmodul 7. Analog gilt dies für die Module 11, 12, 13 und 4.

Mit der Modulbauweise ist sowohl eine Funktionstrennung als auch eine Funktionsintegration möglich, sodass eine für die Funktion und/oder Kosten optimierte Imprintanlage 15 hergestellt wird. Demnach ist es in einer weiteren erfindungsgemäßen Ausführungsform der Imprintanlage möglich, ausschließlich das Prägemodul 2 zu beinhalten. Weiterhin ist in einer anderen erfindungsgemäßen Ausführungsform eine Kombination des Prägemoduls 2 mit dem Regelungsmodul 14 denkbar. Alle kombinatorischen Möglichkeiten aus mindestens einem der Module für die Imprintanlage 15 (insbesondere Modul 2) sollen als offenbart gelten.

### Bezugszeichen

- A: Ausschnitt
- n1, n2, n3: Brechungsindizes
- G, H: Grenzflächen
- M1, M2, O: Medien, Festkörper mit unterschiedlichen Brechungsindizes
- I, I1, I2, I3: Intensität einer Strahlung, insbesondere Licht
- x, k: Abstand
- e: Exponentialfunktion
- c: Grenzwinkel der Totalreflexion
- α, β: Brechungswinkel
- F: Prägekraft
- F': Gegenkraft
- bp: Breite der Prägerolle
- D: Außendurchmesser der Prägerolle
- L: eingekoppelte Strahlung, insbesondere Licht
- d: Innendurchmesser der Prägerolle
- s: Verspiegelte Fläche
- 1k: Lichtkopplungsfläche, insbesondere eine Kavität
- t, t', t", t‴: Trennwand zwischen den Segmenten
- 1: Sendemodul
- 2, 2', 2", 2‴,: Prägemodul, insbesondere Prägerolle
- 2ʺʺ, 2ʺ‴, 2‴‴, 2‴‴ 2a: äußere Zylindermantelfläche der Prägerolle
- 2i: innere funktionelle Mantelfläche der Prägerolle
- 2ik: innere funktionelle Mantelfläche der Prägerolle, konisch ausgeführt
- 2k: Kopplungsfläche (Stirnfläche der Prägerolle) mit Koppelelementen und Teilverspiegelung
- 2s: Stirnfläche der Prägerolle (zur Strahlungseinkopplung)
- 2sp: verspiegelte Stirnfläche der Prägerolle
- 3: Stützmodul
- 4: Empfängermodul
- 5: Trägermantel
- 6: oberes Beschichtungsmodul
- 7: unteres Beschichtungsmodul
- 8: Kraft- bzw. Druckerzeugungselemente, insbesondere Antriebe, Motoren
- 9: Strahlungsmodul mit mindestens einer Strahlungsquelle
- 10: Führungs- und/oder Vorspannungs- und/oder Fügemodul für Reinigungs-
- 11: und/oder Deionisierung Regelungs- und/oder Führungsmodul
- 12, 13: Module für Schutzschicht- und/oder Schutzfolienauftrag und/oder vollständige Aushärtemodul und/oder Vorspannungs- und/oder Deionisiermodul
- 14: Mess- und/oder Steuerungs- und/oder Regelungsmodul oder Module
- 15: Imprintanlage
- 16: Zylinderkörper
- 16a: Außenmantelfläche des Zylinderkörpers
- 16k: Außenmantelfläche des Zylinderkörpers, konisch ausgeführt
- 16s: Störstellen zur forcierten Strahlungsauskopplung an der Außenmantelfläche des Zylinderkörpers 16a
- 17: Prägemasse
- 18, 18': Strahlformer zur Einkopplung, insbesondere optische Keile, Linsen, Prismen, Spiegel, Blenden

## Patentansprüche

1. Verfahren zum Prägen von Mikro- und/oder Nanostrukturen, aufweisend die folgenden Schritte:
- Einkoppeln einer Vernetzungsstrahlung (L) in eine für die Vernetzungsstrahlung durchsichtige, insbesondere strukturierte, Prägerolle (2, 2', 2", 2‴, 2"", 2ʺ‴, 2""", 2‴‴′), sodass die Prägerolle (2, 2', 2", 2‴, 2ʺʺ, 2ʺ‴, 2""", 2‴‴′) als Lichtleiter für die eingekoppelte Vernetzungsstrahlung (L) dient,
- Auskoppeln der Vernetzungsstrahlung (L) aus der Prägerolle (2, 2', 2ʺ, 2‴, 2ʺʺ, 2‴ʺ, 2‴‴, 2‴‴′),
- Aushärtung einer durch die Prägerolle (2, 2′, 2ʺ, 2‴, 2ʺʺ, 2ʺ‴, 2‴‴, 2′‴‴) beaufschlagten Prägemasse (17) durch die ausgekoppelte Vernetzungsstrahlung (L).

2. Verfahren nach Anspruch 1, **dadurch gekennzeichnet, dass** die Vernetzungsstrahlung (L) an mindestens einer der Stirnflächen (2k) der Prägerolle (2, 2′, 2ʺ, 2‴, 2ʺʺ, 2ʺ‴, 2""", 2‴‴′) eingekoppelt wird.

3. Verfahren nach einem der vorhergehenden Ansprüche, **dadurch gekennzeichnet, dass** mindestens ein Sendemodul (1) die Vernetzungsstrahlung (L) in die Prägerolle (2, 2′, 2ʺ, 2‴, 2ʺʺ, 2ʺ‴, 2‴‴, 2′‴‴) einkoppelt.

4. Verfahren nach einem der vorhergehenden Ansprüche, **dadurch gekennzeichnet, dass** die Vernetzungsstrahlung (L) UV-Strahlung ist.

5. Verfahren nach einem der vorhergehenden Ansprüche, **dadurch gekennzeichnet, dass** mehrere Totalreflexionen der Vernetzungsstrahlung (L) innerhalb der Prägerolle (2, 2′, 2ʺ, 2‴, 2ʺʺ, 2ʺ‴, 2‴‴, 2‴‴) erfolgen.

6. Verfahren nach einem der vorhergehenden Ansprüche, **dadurch gekennzeichnet, dass** die Vernetzungsstrahlung (L) mittels frustrierter Totalreflexion aus der Prägerolle (2, 2′, 2ʺ, 2‴, 2"", 2ʺ‴, 2‴‴, 2‴‴′) aus- und gleichzeitig in die Prägemasse (17) zur Aushärtung eingekoppelt wird.

7. Verfahren nach einem der vorhergehenden Ansprüche, **dadurch gekennzeichnet, dass** die Vernetzungsstrahlung (L) durch Streustellen (16s) ausgekoppelt wird.

8. Verfahren nach einem der vorhergehenden Ansprüche, **dadurch gekennzeichnet, dass** die Prägemasse (17) mittels der Prägerolle (2, 2′, 2ʺ, 2‴, 2ʺʺ, 2ʺ‴, 2‴‴, 2‴‴′) geformt wird und zeitlich minimal verzögert oder gleichzeitig die Aushärtung der Prägemasse (17) durch die Vernetzungsstrahlung (L) erfolgt.

9. Vorrichtung (15) zum Prägen von Mikro- und/oder Nanostrukturen, aufweisend:
-- ein Sendemodul (1) zum Aussenden einer Vernetzungsstrahlung (L),
-- eine für die Vernetzungsstrahlung durchsichtige Prägerolle (2, 2′, 2ʺ, 2‴, 2ʺʺ, 2‴ʺ, 2‴‴, 2‴‴′),
wobei die Vernetzungsstrahlung (L) in die Prägerolle (2, 2′, 2ʺ, 2‴, 2ʺʺ, 2ʺ‴, 2‴‴, 2‴‴′) einkoppelbar ist, sodass die Prägerolle (2, 2′, 2ʺ, 2‴, 2ʺʺ, 2ʺ‴, 2‴‴, 2‴‴′) als Lichtleiter für die eingekoppelte Vernetzungsstrahlung (L) verwendbar ist, wobei die Vernetzungsstrahlung (L) aus der Prägerolle (2, 2′, 2ʺ, 2‴, 2ʺ, 2ʺ‴, 2‴‴, 2‴‴′) auskoppelbar ist und eine durch die Prägerolle (2, 2′, 2ʺ, 2‴, 2ʺʺ, 2ʺ‴, 2‴‴, 2‴‴′) beaufschlagte Prägemasse (17) durch die ausgekoppelte Vernetzungsstrahlung (L) aushärtbar ist.

10. Prägerolle (2, 2′, 2ʺ, 2‴, 2ʺʺ, 2ʺ‴, 2‴‴, 2‴‴′) konfiguriert, so dass ein Verfahren nach Anspruch 1 durchführbar ist.

11. Prägerolle (2, 2′, 2ʺ, 2‴, 2ʺʺ, 2ʺ‴, 2‴‴, 2‴‴′) nach Anspruch 10, wobei eine innere Mantelfläche (2ik) der Prägerolle (2, 2′, 2ʺ, 2‴, 2ʺʺ, 2‴ʺ, 2‴‴, 2′‴‴) konisch ausgebildet ist.

12. Prägerolle (2, 2′, 2ʺ, 2‴, 2ʺʺ, 2ʺ‴, 2‴‴, 2‴‴′) nach Anspruch 10, wobei mindestens eine der Stirnflächen (2s, 2sk) der Prägerolle (2, 2′, 2ʺ, 2‴, 2ʺʺ, 2ʺ‴, 2‴‴, 2‴‴′ für die Strahlungseinkoppelung mit Teilverspiegelungen und/oder Rillen und/oder Kerben versehen ist.

13. Prägerolle (2, 2′, 2ʺ, 2‴, 2ʺʺ, 2ʺ‴, 2‴‴, 2‴‴′) nach Anspruch 10, wobei die Vernetzungsstrahlung (L) einseitig in eine Stirnfläche (2s, 2sk) der Prägerolle (2, 2′, 2ʺ, 2‴, 2ʺʺ, 2ʺ‴, 2‴‴, 2‴‴′) einkoppelbar ist und die gegenüberliegende Stirnfläche (2sp) totalverspiegelt ist.

## Claims

1. A method for embossing micro and/or nanostructures, having the following steps:
- coupling cross-linking radiation (L) into an embossing roller (2, 2′, 2ʺ, 2‴, 2ʺʺ, 2ʺ‴, 2‴‴, 2′‴‴), which is transparent and in particular structured, so that the embossing roller (2, 2′, 2ʺ, 2‴, 2ʺʺ, 2ʺ‴, 2‴‴, 2‴‴′) is used as an optical waveguide for the cross-linking radiation (L) that is coupled-in,
- decoupling the cross-linking radiation (L) from the embossing roller (2, 2′, 2ʺ, 2‴, 2ʺʺ, 2ʺ‴, 2‴‴, 2′‴‴),
- curing an embossing compound (17) loaded by the embossing roller (2, 2′, 2ʺ, 2‴, 2ʺʺ, 2ʺ‴, 2‴‴, 2‴‴′) by means of the decoupled cross-linking radiation (L).

2. The method according to Claim 1, **characterized in that** the cross-linking radiation (L) is coupled-in at least at one of the end faces (2k) of the embossing roller (2, 2′, 2ʺ, 2‴, 2ʺʺ, 2ʺ‴, 2‴‴, 2‴‴′).

3. The method according to one of the preceding claims, **characterized in that** at least one transmission module (1) couples the cross-linking radiation (L) into the embossing roller (2, 2′, 2ʺ, 2‴, 2ʺ, 2ʺ‴, 2‴‴, 2′‴‴).

4. The method according to one of the preceding claims, **characterized in that** the cross-linking radiation (L) is UV radiation.

5. The method according to one of the preceding claims, **characterized in that** a plurality of total internal reflections of the cross-linking radiation (L) take place inside the embossing roller (2, 2′, 2ʺ, 2‴, 2ʺʺ, 2ʺ‴, 2‴‴, 2′‴‴).

6. The method according to one of the preceding claims, **characterized in that** the cross-linking radiation (L) is decoupled from the embossing roller (2, 2′, 2ʺ, 2‴, 2ʺʺ, 2ʺ‴, 2‴‴, 2‴‴′) by means of frustrated total internal reflection and simultaneously coupled into the embossing compound (17) for curing.

7. The method according to one of the preceding claims, **characterized in that** the cross-linking radiation (L) is decoupled through scattering points (16s).

8. The method according to one of the preceding claims, **characterized in that** the embossing compound (17) is shaped by means of the embossing roller (2, 2′, 2ʺ, 2‴, 2ʺʺ, 2ʺ‴, 2‴‴, 2′‴‴) and, in a minimally temporally delayed manner or simultaneously, the curing of the embossing compound (17) takes place by means of the cross-linking radiation (L).

9. A device (15) for embossing micro and/or nanostructures, having:
-- a transmission module (1) for radiating cross-linking radiation (L),
-- an embossing roller (2, 2′, 2ʺ, 2‴, 2ʺʺ, 2ʺ‴, 2‴‴, 2′‴‴) which is transparent for the cross-linking radiation,
wherein the cross-linking radiation (L) can be coupled into the embossing roller (2, 2′, 2ʺ, 2‴, 2ʺʺ, 2ʺ‴, 2‴‴, 2‴‴′), so that the embossing roller (2, 2′, 2ʺ, 2‴, 2ʺʺ, 2ʺ‴, 2‴‴, 2′‴‴) can be used as an optical waveguide for the cross-linking radiation (L) that is coupled-in, wherein the cross-linking radiation (L) can be decoupled from the embossing roller (2, 2′, 2ʺ, 2‴, 2ʺʺ, 2ʺ‴, 2‴‴, 2‴‴′) and an embossing compound (17) loaded by the embossing roller (2, 2′, 2ʺ, 2‴, 2ʺʺ, 2ʺ‴, 2‴‴, 2′‴‴) can be cured by the decoupled cross-linking radiation (L).

10. An embossing roller (2, 2′, 2ʺ, 2‴, 2ʺʺ, 2ʺ‴, 2‴‴, 2′‴‴) which is configured so that a method according to Claim 1 can be carried out.

11. The embossing roller (2, 2′, 2ʺ, 2‴, 2ʺʺ, 2ʺ‴, 2‴‴, 2′‴‴) according to Claim 10, wherein an inner contacting surface (2ik) of the embossing roller (2, 2′, 2ʺ, 2‴, 2ʺʺ, 2ʺ‴, 2‴‴, 2′‴‴) is of conical construction.

12. The embossing roller (2, 2′, 2ʺ, 2‴, 2ʺʺ, 2ʺ‴, 2‴‴, 2′‴‴) according to Claim 10, wherein at least one of the end faces (2s, 2sk) of the
embossing roller (2, 2′, 2ʺ, 2‴, 2ʺʺ, 2ʺ‴, 2‴‴, 2′‴‴) is provided with partial mirrorings and/or grooves and/or notches for coupling in the radiation.

13. The embossing roller (2, 2′, 2ʺ, 2‴, 2ʺʺ, 2ʺ‴, 2‴‴, 2′‴‴) according to Claim 10, wherein the cross-linking radiation (L) can be coupled into an end face (2s, 2sk) of the embossing roller (2, 2′, 2ʺ, 2‴, 2ʺʺ, 2ʺ‴, 2‴‴, 2′‴‴) on one side and the opposite end face (2sp) is totally mirrored.

## Revendications

1. Procédé de marquage de microstructures et/ou nanostructures, présentant les étapes suivantes :
- entrée d'un rayonnement de réticulation (L) dans un rouleau de marquage (2, 2′, 2ʺ, 2‴, 2ʺʺ, 2ʺ‴, 2‴‴, 2′‴‴) transparent au rayonnement de réticulation, en particulier structuré, de sorte que le rouleau de marquage (2, 2′, 2ʺ, 2‴, 2ʺʺ, 2ʺ‴, 2‴‴, 2′‴‴) sert de conducteur optique pour le rayonnement de réticulation (L) entré,
- sortie du rayonnement de réticulation (L) hors du rouleau de marquage (2, 2′ 2ʺ, 2‴, 2ʺʺ, 2ʺ‴, 2‴‴, 2′‴‴),
- durcissement d'une masse de marquage (17) sollicitée par le rouleau de marquage (2, 2′, 2ʺ, 2‴, 2ʺ, 2ʺ‴, 2‴‴, 2′‴‴) par le rayonnement de réticulation (L) sorti.

2. Procédé selon la revendication 1, **caractérisé en ce que** le rayonnement de réticulation (L) est entré sur au moins une des faces avant (2k) du rouleau de marquage (2, 2′, 2ʺ, 2‴, 2ʺʺ, 2ʺ‴, 2‴‴, 2′‴‴).

3. Procédé selon l'une des revendications précédentes, **caractérisé en ce qu'**au moins un module d'émission (1) fait entrer le rayonnement de réticulation (L) dans le rouleau de marquage (2, 2′, 2ʺ, 2‴, 2ʺʺ, 2ʺ‴, 2‴‴, 2′‴‴).

4. Procédé selon l'une des revendications précédentes, **caractérisé en ce que** le rayonnement de réticulation (L) est un rayonnement UV.

5. Procédé selon l'une des revendications précédentes, **caractérisé en ce que** plusieurs réflexions totales du rayonnement de réticulation (L) ont lieu à l'intérieur du rouleau de marquage (2, 2′, 2ʺ, 2‴, 2ʺʺ, 2ʺ‴, 2‴‴, 2′‴‴).

6. Procédé selon l'une des revendications précédentes, **caractérisé en ce que** le rayonnement de réticulation (L) est sorti hors du rouleau de marquage (2, 2′, 2ʺ, 2‴, 2ʺʺ, 2ʺ‴, 2‴‴, 2′‴‴) au moyen de réflexion totale frustrée et entré parallèlement dans la masse de marquage (17) pour le durcissement.

7. Procédé selon l'une des revendications précédentes, **caractérisé en ce que** le rayonnement de réticulation (L) est sorti par des points de diffusion (16s).

8. Procédé selon l'une des revendications précédentes, **caractérisé en ce que** la masse de marquage (17) est formée au moyen du rouleau de marquage (2, 2′, 2ʺ, 2‴, 2ʺʺ, 2ʺ‴, 2‴‴, 2′‴‴) et le durcissement de la masse de marquage (17) a lieu avec un retard temporel minimal ou en même temps par le rayonnement de réticulation (L).

9. Dispositif (15) de marquage de microstructures et/ou nanostructures, présentant :
-- un module d'entrée (1) pour envoyer un rayonnement de réticulation (L),
-- un rouleau de marquage (2, 2′, 2ʺ, 2‴, 2ʺʺ, 2‴, 2‴‴, 2′‴‴) transparent au rayonnement de réticulation,
dans lequel le rayonnement de réticulation (L) peut être entré dans le rouleau de marquage (2, 2′, 2ʺ, 2‴, 2ʺʺ, 2ʺ‴, 2‴‴, 2′‴‴), de sorte que le rouleau de marquage (2, 2′, 2ʺ, 2‴, 2ʺʺ, 2ʺ‴, 2‴‴, 2′‴‴) puisse être utilisé en tant que conducteur optique pour le rayonnement de réticulation (L) entré, dans lequel le rayonnement de réticulation (L) peut être sorti hors du rouleau de marquage (2, 2′, 2ʺ, 2‴, 2ʺʺ, 2ʺ‴, 2‴‴, 2′‴‴) et une masse de marquage (17) sollicitée par le rouleau de marquage (2, 2′, 2ʺ, 2‴, 2ʺʺ, 2ʺ‴, 2‴‴, 2′‴‴) peut être durcie par le rayonnement de réticulation (L) sorti.

10. Rouleau de marquage (2, 2′, 2ʺ, 2‴, 2ʺʺ, 2ʺ‴, 2‴‴, 2′‴‴) configuré de façon à ce qu'un procédé selon la revendication 1 puisse être exécuté.

11. Rouleau de marquage (2, 2′, 2ʺ, 2‴, 2ʺʺ, 2ʺ‴, 2‴‴, 2′‴‴) selon la revendication 10, dans lequel une surface d'enveloppe intérieure (2ik) du rouleau de marquage (2, 2′, 2ʺ, 2‴, 2ʺʺ, 2ʺ‴, 2‴‴, 2′‴‴) est conique.

12. Rouleau de marquage (2, 2′, 2ʺ, 2‴, 2ʺʺ, 2ʺ‴, 2‴‴, 2′‴‴) selon la revendication 10, dans lequel au moins une des faces avant (2s, 2sk) du rouleau de marquage (2, 2′, 2ʺ, 2‴, 2ʺʺ, 2ʺ‴, 2‴‴, 2′‴‴) est dotée de miroirs réfléchissants et/ou de nervures et/ou d'encoches pour l'entrée du rayonnement.

13. Rouleau de marquage (2, 2′, 2ʺ, 2‴, 2ʺʺ, 2ʺ‴, 2‴‴, 2‴‴′) selon la revendication 10, dans lequel le rayonnement de réticulation (L) peut être entré d'un côté dans une face avant (2s, 2sk) du rouleau de marquage (2, 2′, 2ʺ, 2‴, 2ʺʺ, 2‴ʺ, 2‴‴, 2′‴‴) et la face avant (2sp) opposée est totalement dotée de miroirs réfléchissants.
